# EUROPEAN PATENT SPECIFICATION

(11) **EP 2 738 141 B1**
(45) Date of publication and mention of the grant of the patent: **22.05.2019**
(21) Application number: 12818442.1
(22) Date of filing: 11.07.2012
(51) Int. Cl.: C30B 29/06, C30B 35/00, C01B 33/027, B01J 19/02, C01B 32/956, C01B 33/03

(54) **POLYSILICON RECEPTACLE**
POLYSILICIUMBEHÄLTER
RÉCIPIENT DE SILICIUM POLYCRISTALLIN

(30) Priority: 25.07.2011 JP 2011162431
(43) Date of publication of application: 04.06.2014
(73) Proprietor: Tokuyama Corporation, Shunan-shi, Yamaguchi-ken 745-8648 (JP)
(72) Inventor: SAKIDA, Manabu, Yamaguchi 745-8648 (JP); KAWAI, Hideaki, Yamaguchi 745-8648 (JP); WAKAMATSU, Satoru, Yamaguchi 745-8648 (JP)
(74) Representative: J A Kemp
(86) International application number: PCT/JP2012/067739
(87) International publication number: WO 2013/015119

(56) References cited:
- EP-A1- 0 294 047
- EP-A1- 0 983 981
- EP-A1- 1 661 857
- EP-A1- 1 772 430
- EP-A1- 2 223 893
- WO-A1-2010/113299
- JP-A- 10 182 133
- JP-A- S62 108 515
- JP-A- 2004 002 138
- JP-A- 2005 271 058
- JP-A- 2010 037 159
- JP-A- 2011 073 914
- US-A- 5 045 398
- US-A1- 2007 264 173
- Takeshi Saito ET AL: "A reusable mold in directional solidification for silicon solar cells", SOLAR ENERGY MATERIALS, vol. 9, no. 3, 1 October 1983 (1983-10-01) , pages 337-345, XP055395032, AMSTERDAM, NL ISSN: 0165-1633, DOI: 10.1016/0165-1633(83)90055-2

## Description

### Technical Field:

This invention relates to a polysilicon receptacle used in a process for the production of silicon.

### Background Art:

A variety of methods have heretofore been known for producing silicon that is used as a starting material of semiconductors and wafers for solar power generation. One of the methods that has been placed in practice already on an industrial scale is a method called the Siemens method in which a silicon rod heated by flowing an electric current at a temperature at which silicon deposits is arranged in a bell jar and in which a trichlorosilane (SiHCl₃) and a monosilane (SiH₄) are brought into contact with a reducing gas such as hydrogen or the like to deposit silicon. This method has a feature in that silicon of a high purity is obtained, and has been placed in practice as the most generally employed method.

As another method, there has, further, been known a method in which a mixed gas (starting gas) of the trichlorosilane and hydrogen is fed into a reactor (Si melt-depositing reactor) heated at a temperature higher than the temperature at which silicon deposits so that silicon deposits on the inner wall surface of the reactor, the deposited silicon is melted so as to fall down into a receptacle arranged in a collector coupled to the lower part of the reactor, and the silicon is cooled, solidified and is taken out (patent document 1).

EP 2 223 893 A1 discloses an apparatus for providing silicon, comprising a recovery container provided with moving means for moving the recovery container so as to vary the position at which silicon drips into the container.

### Prior Art Document:

### Patent Document:

Patent document 1: Japanese Patent No. 3958092

Takeshi Saito ET AL: "A reusable mold in directional solidification for silicon solar cells", SOLAR ENERGY MATERIALS, vol. 9, no. 3, 1 October 1983 (1983-10-01), pages 337-345, XP055395032, AMSTERDAM, NL ISSN: 0165-1633, DOI: 10.1016/0165-1633(83)90055-2, discloses background information.

EP 1 772 430 A1 (TOKUYAMA CORP [JP]) 11 April 2007 (2007-04-11), discloses background information.

JP S62 108515 A (OSAKA TITANIUM) 19 May 1987 (1987-05-19), discloses background information.

### Outline of the Invention:

### Problems that the Invention is to Solve:

When the molten silicon is recovered in the receptacle and the polysilicon (polycrystalline silicon) is taken out from the receptacle, however, the surfaces thereof are often locally degenerated. The degeneration appears in the form of discoloration or delustering and is, usually, called stain. Development of such stain impairs characteristics such as semiconductor characteristics, and it is presumed that the solar cells using the polysilicon may lose cell performance.

It is, therefore, an object of the present invention to provide a polysilicon receptacle arranged at the lower part of the Si melt-depositing reactor, and receives the polysilicon therein without degenerating the surfaces of the polysilicon.

### Means for Solving the Problems:

The invention is set out in claim 1.

The present inventors have forwarded the study by extensively conducting experiments concerning the polysilicon taken out from the polysilicon receptacle arranged at the lower part of the Si melt-depositing reactor and, as a result, have newly discovered the fact that the water content released from the receptacle is a cause of degeneration on the surfaces of the polysilicon contained in the receptacle.

Namely, there is provided a polysilicon receptacle made of a carbon material for being arranged under a silicon melt-depositing reactor to receive polysilicon that melt-drips from the inner surface of the reactor to outside the reactor, wherein at least the inner surface of the receptacle is covered with a surface-treating layer to prevent water from being released by the carbon material.

In the polysilicon receptacle further:
(1) The surface-treating layer is an SiC layer;
(2) The polysilicon receptacle is made of a carbon material provided with the surface-treating layer;
(3) The surface-treating layer is formed by applying a paste that contains a silicon powder and a binder resin, followed by firing; and
(4) The polysilicon receptacle is fabricated by stacking many blocks of the carbon material, and forming the surface-treating layer on the surfaces of the blocks of the carbon material.

### Effects of the Invention:

The polysilicon receptacle of the present invention is provided with the surface-treating layer that prevents absorption and release of water content. Formation of the surface-treating layer effectively prevents the polysilicon contained in the receptacle from being locally degenerated on the surfaces thereof.

As demonstrated in Examples 1 and 2 appearing later, for example, it was confirmed that stain (surface degeneration) was not observed at all when the receptacle formed by stacking graphite blocks having a surface-treating layer (SiC layer) was arranged at the lower part of the Si melt-depositing reactor, and when the polysilicon was obtained by permitting the silicon deposited in the reactor to melt-drip into the receptacle and by cooling and solidifying the silicon contained in the receptacle.

On the other hand, according to Comparative Example 1 that has used the receptacle formed by stacking the same graphite blocks without, however, forming the surface-treating layer, the polysilicon was obtained having stains formed thereon.

As described above, the present inventors consider that the polysilicon recovered and obtained by using the polysilicon receptacle provided with the surface-treating layer according to the present invention, is effectively prevented from being degenerated on the surfaces thereof probably because the degeneration on the surfaces is caused by water content and provision of the surface-treating layer prevents the contact between the polysilicon and the water content.

As the materials for forming the polysilicon receptacle, there have been known non-metallic materials such as carbon (graphite), quartz (SiO₂), silicon nitride and alumina, as well as metal materials such as stainless steel, molybdenum and tungsten. Among them, however, the non-metallic material is preferably used for the receptacle from the standpoint of heat resistance and reactivity for the molten silicon since the receptacle comes in contact with the molten silicon (silicon melt) of a high temperature. Specifically, the carbon material is most desirably used from the standpoint of its excellence in the property of peeling off from the molten silicon.

Here, if compared to metal materials, the non-metallic material suited as the receptacle material is a porous material containing therein pores of from about several Å to several *µ*m and has hygroscopic property. That is, by using the receptacle made of the material having hygroscopic property, if the wall surface of the receptacle is heated at a high temperature upon coming in contact with the molten silicon, then the water content adsorbed by the wall surface is released (emitted) as water vapor and works as an oxygen source causing oxidation and deterioration on the surfaces of the polysilicon and degenerating the surfaces thereof to appear as so-called stain. Namely, the surface degeneration is considered to be due to an oxide film. Formation of the oxide film lowers properties of the polysilicon when it is used as a semiconductor material, as a matter of course.

On the other hand, the polysilicon receptacle of the present invention has the surface-treating layer formed on at least the inner surface of the receptacle. The surface-treating layer covers up the pores that absorb and release water content, and not only prevents absorption of water content by the inner surface of the receptacle but also prevents release of water content from inside the surface irrespective of if water content has been absorbed therein (by its own nature, very little water has been adsorbed therein to be released). As a result, the polysilicon receptacle of the invention becomes capable of effectively preventing the surface degeneration (deterioration by oxidation) of the polysilicon caused by the water content.

It can be contrived to prevent the water content from being released by installing the receptacle in the apparatus for producing the silicon instead of forming the surface-treating layer right after it was dried in a drying furnace. In this case, however, the inner surface of the receptacle is exposed to the atmosphere and absorbs water content during the period of until the apparatus is operated after the receptacle is dried. Therefore, the water content cannot be prevented from being released, and the surface degeneration of the polysilicon cannot be avoided.

It can be, further, contrived to dry the receptacle after it is arranged in the apparatus for producing the silicon. In this case, however, the water content which could contaminate the silicon is positively fed into the production apparatus. Therefore, this means cannot be employed, either.

In this invention, the surface treatment is a treatment for covering up the pores that serve as sites where the water content is absorbed, and stands for a surface coating that is applied and fired or vacuum deposited. For instance, a paste containing a silicon powder and a binder resin is used as a surface-treating agent, applied onto the predetermined receptacle material and is fired to form an SiC layer that serves as the surface-treating layer. There have, further, been known heat-resistant ceramics such as SiC ceramic and the like as a material of the polysilicon receptacle. When the SiC ceramic is used as the receptacle material, too, however, it is necessary to treat the surface according to the present invention. That is, the receptacle material comprising the SiC ceramic, too, is porous, much contains pores that serve as sites for absorbing water content, and absorption of water content cannot be prevented unless the pores are covered up. After all, the water content that is absorbed cannot be prevented from being released unless the surface is treated.

In the polysilicon receptacle of the present invention as described above, the surface-treating layer is formed on at least the inner surface of the material forming the receptacle to prevent the absorption of water content. Therefore, even when the inner surface of the receptacle is heated at a high temperature upon coming in contact with the silicon melt, the water content that is absorbed is effectively prevented from being released making it possible to effectively prevent the polisilicon contained in the receptacle from being degenerated on the surfaces and offering great advantage in obtaining the polysilicon of high quality.

### Brief Description of the Drawings:

[Fig. 1] is a view schematically illustrating the structure of a polysilicon production line in which a polysilicon receptacle is arranged at the lower part of an Si melt-depositing reactor.
[Fig. 2] is a schematic perspective view of a preferred polysilicon receptacle of the present invention.

### Modes for Carrying Out the Invention:

### <Polysilicon production line>

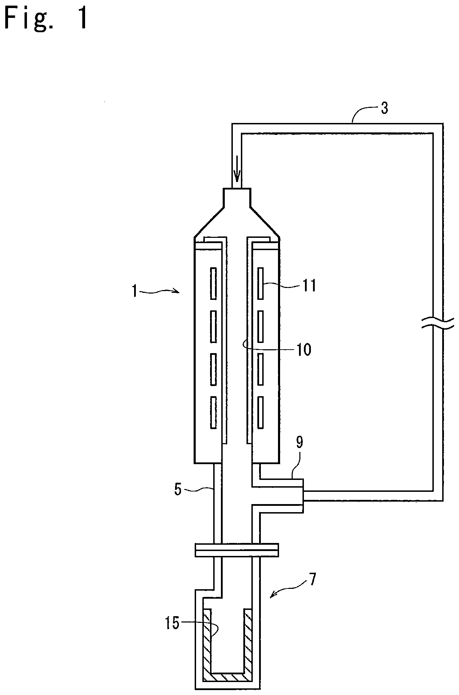

Referring to Fig. 1 schematically illustrating the polysilicon production line, the production line is provided with an Si melt-depositing reactor 1 of cylindrical shape. A gas circulation pipe 3 is coupled to the upper part of the reactor 1, a gas discharge tube 5 is connected to the lower part of the reactor 1, and a collector 7 is connected to the lower end of the gas discharge tube 5, the collector 7 having a cylindrical shape and being closed at the lower end thereof, and the connections being made maintaining hermetic sealing. Further, a communication pipe 9 is formed in the side surface of the gas discharge tube 5 at an upper part thereof, and the other end of the gas circulation pipe 3 is coupled to the communication pipe 9 via a suitable valve.

A reaction tube 10 stretches up and down in the Si melt-depositing reactor 1, and the gas fed from the upper end of the reactor 1 is discharged into the gas discharge tube 5 via the reactor tube 10, and the gas discharged into the gas discharge tube 5 is discharged into the gas circulation pipe 3 via the communication pipe 9.

A heating coil 11 is arranged surrounding the reaction tube 10, and the inner wall surface of the reaction tube 10 is heated at a temperature higher than a temperature at which the silicon deposits and higher than a melting point of the silicon.

A polysilicon receptacle 15 formed according to the present invention is held in the collector 7.

In the production line described above, a mixed gas of, for example, a trichlorosilane gas and a hydrogen gas is fed into the reactor 1 from the circulation pipe 3, and passes through the reaction tube 10 on the inside. The reaction tube 10 is heated by the heating coil 11 at a temperature higher than the temperature at which silicon deposits. Therefore, silicon (Si) deposits on the inner wall surface of the reaction tube 10 according to the following reducing reaction:

SiHCl₃ + H₂ → Si + 3HCl

If the reaction tube 10 is further heated to a temperature higher than the melting point of silicon at a moment when the silicon has deposited in a predetermined amount on the inner surface of the reaction tube 10, then the deposited silicon creeps down as a silicon melt in a molten state along the inner wall surface of the reaction tube 10. The silicon melt passes through the gas discharge tube 5 arranged under the reactor 1, contained in the polysilicon receptacle 15 in the collector 7 coupled to the lower part thereof, cooled and solidified in the receptacle 15, and the polysilicon is taken out.

On the other hand, the gas introduced into the reactor 1 passes through the reaction tube 10, is discharged into the gas discharge tube 5, and is returned back into the gas circulation pipe 3 from the communication pipe 9 formed in the gas discharge tube 5.

Though not shown, the gas circulation pipe 3 is provided with a blower such as compressor and various heat exchangers and adsorption towers. That is, the exhaust gas that passes through the reaction tube 10 and flows into the circulation pipe 3 through the gas discharge tube 5 comprises chiefly a hydrogen gas which contains unreacted trichlorosilane, by-produced hydrogen chloride and tetrachlorosilane. Therefore, upon chilling by using a heat exchanger or the like, the chlorosilane gas is condensed and separated. Further, the hydrogen chloride is separated through the adsorption tower that uses activated carbon, the hydrogen gas is circulated into the reactor 1, the trichlorosilane and the like are recovered by distillation from the chlorosilane that is separated by condensation, the chlorosilane gas such as trichlorosilne that is recovered is returned again into the circulation pipe 3 and is fed into the reactor 1 together with the hydrogen gas.

In the above production line, it is desired that the gas discharge tube 5, collector 7 and communication pipe 9 have a structure in which the inner wall surfaces thereof are cooled to prevent deformation or local deterioration caused by the heat of the high-temperature gas discharged from the reaction tube 10. That is, though any kind of cooling means may be employed here, it is desired that the inner wall surfaces are maintained at temperatures lower than the reaction temperature (temperature at which the silicon deposits) by providing, for example, water-cooled jackets on the outer surfaces of the above members.

It is desired that the inner walls of the reaction tube 10 and the inner surfaces of the gas discharge tube 5 are formed by using a carbon material (e.g., graphite) that has excellent resistance against the heat since they are subject to be heated at temperatures higher than the melting point of the silicon or come in contact with the silicon melt of a high temperature so that they will not adversely affect the reaction of the silane gas with hydrogen and will not release impurities that adversely affect properties of the polysilicon that is formed. That is, the carbon material has excellent resistance against the heat without being deformed or degenerated even if the silicon melt of a high temperature comes in contact therewith. Besides, even in case carbon migrates from the carbon material into the polysilicon that is formed, carbon that has migrated has a small specific gravity. Upon melting the polysilicon, therefore, carbon floats on the surface and can be easily removed by melting the recovered polysilicon again followed by cooling and solidification, and cutting the surfaces away.

### <Polysilicon receptacle>

In the polysilicon production line, the polysilicon receptacle 15 arranged at the lower part of the Si melt-depositing reactor 1 comes in contact with the silicon melt of a high temperature, and is, usually, formed by using a non-metallic material (carbon, quartz, silicon nitride, alumina, etc.) from the standpoint of maintaining resistance against the heat, non-reactivity with the silicon melt and the like, and is, specifically desirably, formed by using a carbon material from the standpoint of non-reactivity with the silicon and property to peel off therefrom.

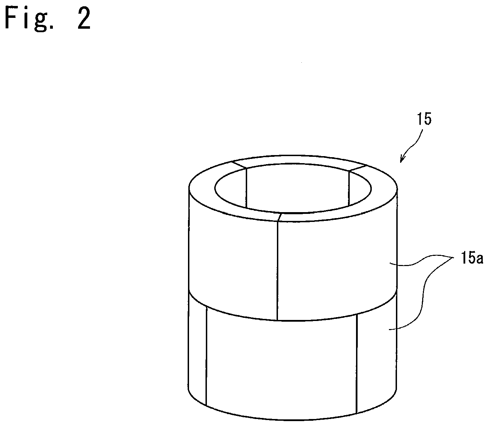

Further, the above production line placed in practice on an industrial scale is considerably large in size to produce the polysilicon in large amounts. Therefore, the polysilicon receptacle 15 (hereinafter often simply called "receptacle") is very large in size correspondingly (e.g., its height exceeds one meter) and, besides, the receptacle wall has a considerably large thickness, too, to maintain a predetermined strength. It will, therefore, be learned that though the receptacle 15 whose scale is industrially large may be formed as a unitary structure by using a suitable mold such as crucible, it is very difficult to form the receptacle as the unitary structure by using such a mold. It is, therefore, desired that the receptacle 15 is fabricated by stacking blocks 15a of a non-metallic material and, specifically, a carbon material as shown in Fig. 2.

The carbon materials are, usually, divided into isotropic graphite materials produced by the CIP forming and the anisotropic graphite materials produced by the extrusion forming or the pressed forming, and contain pores of several Å to several *µ*m therein. The present invention can use either carbon material and, preferably, the isotropic graphite material among them. This is because the isotropic graphite material contains pores of relatively small diameters uniformly. It is, therefore, easy to form a treating layer of a uniform thickness by the surface treatment that will be described later.

Further, the porosity decreases with an increase in the density of the carbon material that is used. From the standpoint of suppressing the release of water content, therefore, it is desired that the carbon material has a large density. If the density becomes unnecessarily large, however, the surface-treating layer formed on the surface thereof tends to be easily stripped off due to a decrease in the anchoring effect. From the above point of view, therefore, it is desired that the carbon material has a density in a range of 1.75 to 1.9 g/cm³.

When the receptacle 15 is to be fabricated by stacking the above blocks 15a, the individual blocks 15a may be simply stacked one upon the other, or the individual blocks 15a may be provided with protuberances such as pins and dents for receiving them. Thus the receptacle 15 is fabricated by using the blocks 15a that are so stacked as can be stably held in the collector 7 due to the engagement among the members.

In the above polysilicon receptacle 15, the non-metallic material and, specifically, the carbon material constituting the receptacle is relatively porous, and is absorbing water content (absorbing water content) in considerable amounts when it is incorporated in the production line due to coming in contact with the atmosphere during the construction. Besides, the polysilicon (silicon melt) deposited and melted in the reaction tube 10 falls down into the receptacle 15 made of the material that contains water content, is cooled and is solidified in the receptacle 15, and is next taken out. It will, therefore, be learned that the receptacle 15 in the state of absorbing water content comes in contact with the silicon melt of a high temperature. Being heated upon coming in contact with the silicon melt, therefore, the water content (water vapor) is released from the receptacle 15 and, as a result, the polysilicon is degenerated on the surface thereof (e.g., the surface is oxidized and deteriorated) due to the water content.

According to the present invention, however, at least the inner surface of the receptacle 15 has been treated and effectively suppresses the absorption of water content or release of water content. It is, therefore, allowed to effectively avoid the degeneration of the polysilicon on the surfaces thereof caused by the water content released from the receptacle 15.

### <Surface treatment>

In the present invention, at least the inner surface of the receptacle 15 is treated so that the water content adsorbed in the container material will not be released even when it is heated at a high temperature upon coming in contact with the silicon melt of a high temperature; i.e., the surface-treated layer is formed on the inner surface to prevent the water vapor from released. Upon covering at least the inner surface of the receptacle 15 with the surface-treating layer, the pores which are the sites where the water content is adsorbed are covered up, absorption of water content and release of water content are prevented on the inner surface of the receptacle 15, and the polysilicon is prevented from being degenerated on the surfaces thereof by the water content that is released. Therefore, it is important that the surface-treating layer formed by the surface treatment is a dense and water-repellant layer which is capable of preventing the water content (water vapor) from being released, has excellent heat resistance, does not form defects such as cracks despite it comes in contact with the silicon melt of a high temperature, and contains no element component that may contaminate the polysilicon that is formed. From the above point of view, therefore, it is desired that the surface-treating layer is formed by the vitreous carbon imbibing treatment, by the coating with thermally decomposed carbon, coating with carbon fiber-reinforced carbon material or coating with SiC. Among them, forming the surface-treating layer with SiC is most desired.

As the surface-treating means, there is no specific limitation so far as the above layer is formed, and there can be employed coating by application or imbibition, coating by firing, vacuum evaporation or CVD. Most desirably, however, the surface treatment based on the coating is employed from such a standpoint that it can be put into practice at a low cost without using any large apparatuses.

The SiC layer which is the most desired surface-treating layer can be formed (i.e., the surface can be treated) by preparing a paste for forming a coating
containing a fine silicon powder, a binder resin and a solvent, and applying the paste onto the surface of a predetermined carbon material followed by firing.

By applying and firing the above paste, the fine silicon powder reacts with carbon on the surface of the carbon material or in the binder resin and forms the SiC layer that is closely adhered to the surface of the carbon material without the need of using a large-scale and expensive apparatus such as vacuum evaporation apparatus.

It is desired that the fine silicon powder used for the paste for coating is a fine powder to enable the coating in which the fine powder is homogeneously dispersed to be formed on the surface of the carbon material. Therefore, the fine silicon powder that is preferably used has a grain size of, for example, not larger than 100 *µ*m. That is, the silicon powder of a coarse grain size is not uniformly distributed when the paste is applied onto the surface of the container material to form the coating and, therefore, the coating on the surface of the receptacle material assumes varying composition which may locally form the portions that permit water vapor to easily escape.

If the grain size becomes smaller than 1 *µ*m, the surfaces of the silicon particles tend to be more easily oxidized. At the time of firing, therefore, oxides such as SiO and SiO₂ are formed much together with the formation of SiC; i.e., SiC is not favorably formed. Therefore, the grain size of the fine silicon powder is in a range of, preferably, 1 to 1000 *µ*m and, specifically, 50 to 500 *µ*m.

When the coating is formed, further, the binder resin works as a binder to let the fine silicon powder stay stably on the surface of the carbon material and, at the same time, works as a carbon source at the time of firing.

There is no specific limitation on the binder resin if it contains carbon in the polymer chain and is capable of easily dissolving in a solvent that will be described later. In general, there can be used a thermoplastic resin without containing foreign elements such as various metal elements like halogen atoms, S atoms, P atoms, Na atoms and the like atoms which when mixed into silicon adversely affect semiconductor properties of silicon. For example, there can be used hydrocarbon resins such as polyolefin, etc., vinyl resins such as polyvinyl alcohol, polyvinyl acetate and polyacrylic acid, and cellulose polymers such as carboxymethyl cellulose (CMC). Among them, the polyvinyl alcohol is most desired from such a standpoint that it is easily available and inexpensive, it enables the fine silicon powder to be easily and homogeneously dispersed and, further, enables the fine silicon powder to easily infiltrate into the porous carbon material.

Further, the solvent is used as a diluent for suitably adjusting the viscosity of the paste for forming coating. There is no specific limitation on the solvent if it is capable of homogeneously dissolving the binder resin, and any solvent can be suitably used depending on the kind of the binder resin. For instance, water is preferably used when there is used a water-soluble resin such as polyvinyl alcohol or CMC as the binder resin. When a water-insoluble resin is used as a binder resin, there is used an alcohol solvent such as methyl alcohol, ethyl alcohol or isopropanol, a ketone solvent such as acetone or methyl ethyl ketone, an aromatic hydrocarbon solvent such as benzene, toluene or xylene, or an ether solvent such as methyl ethyl ether or tetrahydrofurane.

It is desired that the paste for forming the coating contains the fine silicon powder in an amount of 5 to 50 parts by mass and, specifically, 10 to 20 parts by mass per 100 parts by mass of the binder resin. If the amount of the fine silicon powder per the binder resin is smaller than the above range, the fine silicon powder cannot be uniformly distributed on the surface of the container material when the paste is applied onto the surface of the container material and, therefore, the thickness of the surface-treating layer (SiC layer) that is formed may vary. If the fine silicon powder is used in an amount larger than the above range, on the other hand, the amount of the binder resin becomes insufficient. As a result, when the paste for forming the coating is applied onto the surface of the container material, the fine silicon powder tends to easily separate away from the surface of the container material also causing the thickness of the surface-treating layer (SiC layer) that is formed to vary.

The paste for forming the coating containing the above-mentioned components is prepared by mixing and homogeneously dispersing the fine silicon powder in a binder resin solution obtained by dissolving the above-mentioned binder resin in a predetermined solvent.

The paste can be applied and fired (i.e., surface-treated) after the receptacle 15 is fabricated by stacking the predetermined blocks 15a. Usually, however, it is desired to apply and fire (surface-treat) the paste for every block 15a. That is, the receptacle 15 placed in the production line has a considerably large size. Therefore, treating the surfaces of the receptacle 15 requires the application means and the heating means for firing of a considerably large scale. If the receptacle 15 is fabricated by stacking the blocks of the carbon material after they have been treated for their surfaces individually, however, then the paste can be easily applied (e.g., by using a brush or by dipping) and the heating for firing can be easily carried out by using an ordinary heater or the like.

As for treating the surfaces of the blocks 15a, the blocks 15a may be treated on only the surfaces that become the inner surface of the receptacle 15. Usually, however, it is desired that the blocks 15a are treated on their whole surfaces. With the blocks 15a being treated on their whole surfaces, even in case tiny gaps are formed among the blocks 15a that are stacked, it is made possible to effectively prevent release of water content even from the gaps.

The paste may be applied in such an amount that the fine Si powder is distributed in an amount enough to attain water vapor shut-off property to finally prevent the release of water vapor.

Concretely, the amount of application differs depending on the porosity and the like of the container material used for forming the receptacle 15 and cannot be exclusively specified, but is, usually, such that the weight of the fine silicon powder is in a range of 300 to 1000 g/m² and, specifically, 500 to 800 g/m². If the weight of silicon is small, shut-off property against the water content (water vapor) decreases . When heated at a high temperature upon coming in contact with the molten silicon solution, therefore, the water content that has turned into water vapor permeates through the surface-treating layer and may be released. Even if the paste is applied in too large amounts, the water content shut-off property does not increase beyond a predetermined value rather inviting disadvantage in economy and often causing the Si powder to easily split off.

The firing is conducted at a temperature higher than a melting point of the silicon, e.g. , at a temperature of not lower than 1420°C and, specifically, at 1450 to 1600°C. That is, the solvent is removed while the temperature is rising, and the binder resin melts and infiltrates into the surface of the container material incorporating the fine silicon powder therein. Then the binder resin thermally decomposes and carbonizes to form carbon. Next, due to the subsequent firing in the above temperature range, the silicon powder melts completely and, in a state where it is partly infiltrating into the surface of the receptacle material, reacts with carbon that is formed by the carbonization of the binder resin to form silicon carbide (SiC) . Thus the SiC layer which is the surface-treating layer is formed on the surface of the container material.

It is desired that the firing is conducted at the above temperature for not less than 0.5 hours and, specifically, for about 1 to 6 hours, and through which the fine silicon powder is completely melted and is accelerated to infiltrate into the surface of the silicon receptacle material. Due to the reaction of silicon with carbon, further, the SiC layer is formed so as to completely cover the surface of the receptacle material. The SiC layer is formed in a state where the silicon is infiltrating into the surface of the receptacle material or is firmly biting into the surface of the receptacle material. Due to the anchoring effect, therefore, the SiC layer is firmly bonded to the surface of the receptacle material.

In the invention, it is desired that the receptacle material is held at a temperature of about 200 to 300°C for about 30 to 60 minutes while the temperature is being raised up to the above firing temperature. Upon being temporarily held in the above temperature range, the water content adsorbed by the receptacle material such as carbon material is removed therefrom making it possible to effectively prevent the formation of oxide components such as SiO and SiO₂.

After the water content has been removed by heating at the above relatively low temperatures, it is desired that the receptacle material is held at a temperature of about 1000 to 1100°C for about 30 to 60 minutes. Upon being held in the above temperature range, the binder resin is completely carbonized and through the subsequent firing, the SiC layer which is the surface-treating layer is effectively formed.

The polysilicon receptacle 15 of the invention formed by using the thus surface-treated receptacle material effectively prevents the release of water content (water vapor) from the inner surface of the receptacle. Therefore, by installing the above receptacle 15 at the lower part of the Si melt-depositing reactor, it is allowed to produce the polysilicon of high quality without degenerated on the surface thereof that is caused by the water content.

When the polysilicon is produced by using the receptacle 15 that has not been treated on the surface thereof, the SiC is often formed as the Si melt comes in contact with the inner surface of the receptacle. Therefore, it can be considered that upon repetitively using the receptacle 15 used for the production of polysilicon, the SiC layer forms on the inner surface of the silicon receptacle 15 and, as a result, it is allowed to obtain the polysilicon of high quality without fouling. In this case, however, the SiC may form on the inner surface of the receptacle 15 as the Si melt comes in contact thereto, but is not formed as a layer on the whole inner surface; i.e. , the SiC spots are merely formed. This is because the Si melt is readily cooled and solidified after it has come in contact with the inner surface of the receptacle 15. Despite the polysilicon receptacle 15 is repetitively used for the production of polysilicon, therefore, it is not allowed to uniformly form the SiC layer for preventing the absorption and release of water content, and it is not allowed to obtain the polysilicon of high quality.

That is, by uniformly forming the SiC layer on the whole inner surface of the receptacle 15 by the surface treatment mentioned above, it is made possible to obtain the polysilicon of high quality while reliably preventing the silicon from being fouled with the water content.

### EXAMPLES

Excellent effects of the present invention will now be described by way of the following Examples.

### <Example 1>

Six isotropic graphite blocks described below and of which the surfaces have been treated were stacked one upon the other to fabricate a silicon receptacle shown in Fig. 2. Isotropic graphite block:
Bulk density: 1.76 g/cm³
Outer diameter: *φ* 260 mm (divided into three in the circumferential direction)
Inner diameter: *φ* 200 mm (divided into three in the circumferential direction)
Height: 200 mm

The silicon receptacle that was fabricated possessed a size of outer diameter *φ* 260 mm/inner diameter *φ* 200 mm/height 400 mm (about 15 kg), and the graphite blocks were each treated on their surfaces in a manner as described below.

First, as the surface-treating agent, the following fine silicon powder and the binder resin were mixed together to prepare a coating paste containing polyvinyl alcohol in an amount of 15% by mass.
Fine silicon powder: average particle diameter, 300 *µ*m
Binder resin: 10% polyvinyl alcohol (water as a solvent, 90%)

The above coating paste was applied onto the whole surfaces of the graphite blocks such that the weight of the fine silicon powder was 500 to 800 g/m². The blocks were allowed to naturally dry the whole day and night, and were, thereafter, fired for a predetermined period of time to form the SiC layer.

The silicon receptacle fabricated as above was installed at the lower part of the Si melt-depositing reactor 1 shown in Fig. 1 and, thereafter, a mixed gas of hydrogen and trichlorosilane was flown into the reaction tube 10 heated at 1200 to 1400°C so that about 10 kg of silicon has deposited on the inner wall of the reaction tube 10. Thereafter, the reaction tube 10 was heated to be higher than the temperature of the silicon melt so that the silicon that was melted by being heated at 1500 to 1600°C was fallen down into the silicon receptacle installed in the lower part.

After the temperature has been sufficiently lowered down, the silicon in the receptacle was confirmed to find that the silicon receptacle had not been broken and that the silicon had not been stained or degenerated on the surfaces thereof.

Further, the silicon that has fallen down into the receptacle could be easily stripped off, and the receptacle could be used consecutively and repetitively.

In order also to make sure the effect for preventing the absorption or release of the water content, the isotropic graphite block (measuring 10 mm x 15 mm x 7 mm) was provided and was treated on the surfaces thereof under the same conditions as above except the size. Next, by using the Karl Fischer's coulometric titration water content meter (MKC-610,manufactured by KYOTO ELECTRONICS), the amount of water in the surface-treated graphite block after it has been fired, was measured as it was released from normal temperature up to 1000°C. As a result, the content of water in the graphite block was not more than the detectable limit of the device (not more than 10 ppm). Further, the graphite block after measured was left to stand in the open atmosphere at a temperature of 20°C, 1 atm., humidity of 50% for one hour, and was measured again for its content of water to find that the content was not more than the detectable limit.

The above surface-treated graphite block after it has been fired was pulverized, and the surface layer was measured for its thickness to find that the SiC had been formed in a thickness of 1 to 20 *µ*m on the surface thereof and that the SiC had been infiltrated into the graphite block to a depth of 100 to 1000 *µ*m as the carbon material.

### <Example 2>

A silicon receptacle was fabricated in quite the same manner as in Example 1 but using isotropic graphite blocks having a bulk density of 1.88 g/cm³, and was similarly installed at the lower part of the Si melt-depositing reactor 1. The silicon was caused to deposit, and to melt and drop down into the receptacle.

After the temperature has been sufficiently lowered down, the silicon in the receptacle was confirmed to find that the silicon had not been stained or degenerated on the surfaces thereof.

In order also to make sure the effect for preventing the absorption or release of the water content, the isotropic graphite block (measuring 10 mm x 15 mm x 7 mm) having a bulk density of 1.88 g/cm³ was provided and was treated on the surfaces thereof and was measured for its water content under the same conditions as those of Example 1. As a result, the content of water in the graphite block was not more than the detectable limit of the device (not more than 10 ppm) . Further, the graphite block after measured was left to stand in the open atmosphere at a temperature of 20°C, 1 atm., humidity of 50% for one hour, and was measured again for its content of water to find that the content was not more than the detectable limit.

### <Comparative Example 1>

A silicon receptacle was fabricated in quite the same manner as in Example 1 but without treating the surfaces of the isotropic graphite blocks, and was similarly installed at the lower part of the Si melt-depositing reactor 1. The silicon was caused to deposit, and to melt and drop down into the receptacle.

After the temperature has been sufficiently lowered down, the silicon in the receptacle was confirmed to find that the silicon had been stained in brown and blue colors on the upper surfaces thereof and at the portions coming in contact with the receptacle.

Also, the content of water was measured under the same conditions as those of Example 1 but without treating the surfaces. As a result, the content of water in the graphite block was 1100 ppm. Further, the graphite block after measured was left to stand in the open atmosphere at a temperature of 20°C, 1 atm., humidity of 50% for one hour, and was measured again for its content of water to find that the content was as large as 900 ppm.

### Description of Reference Numerals:

1: Si melt-depositing reactor
3: gas circulation pipe
5: gas discharge tube
7: collector
15: polisilicon receptacle

## Claims

1. A polysilicon receptacle (15) made of a carbon material for being arranged under a silicon melt-depositing reactor (1) to receive polysilicon that melt-drips from the inner surface of the reactor (1) to outside the reactor (1), wherein at least the inner surface of said receptacle (15) is covered with a surface-treating layer to prevent water from being released by the carbon material, wherein said surface-treating layer is an SiC layer;
wherein:
said polysilicon receptacle (15) is fabricated by stacking many blocks of the carbon material;
each of the blocks is treated on its whole surface with the surface-treating layer; and
the surface-treating layer is formed by applying and firing a paste, wherein the paste contains a silicon powder and a binder resin.

## Patentansprüche

1. Polysiliziumbehälter (15) aus Kohlenstoffmaterial, um unter einem Siliziumschmelzabscheidungsreaktor (1) angeordnet zu sein, um Polysilizium aufzunehmen, das von der Innenfläche des Reaktors (1) zur Außenseite des Reaktors (1) schmelzt-tropft, wobei mindestens die Innenfläche des Behälters (15) mit einer Oberflächenbehandlungsschicht bedeckt ist, um zu verhindern, dass Wasser von dem Kohlenstoffmaterial freigegeben wird, wobei die Oberflächenbehandlungsschicht eine SiC-Schicht ist;
wobei:
der Polysiliziumbehälter (15) durch Stapeln von vielen Blöcken des Kohlenstoffmaterials hergestellt ist;
jeder der Blöcke auf seiner gesamten Oberfläche mit der Oberflächenbehandlungsschicht behandelt ist; und
die Oberflächenbehandlungsschicht durch Aufbringen und Brennen einer Paste gebildet ist, wobei die Paste ein Siliziumpulver und ein Bindemittelharz enthält.

## Revendications

1. Récipient de silicium polycristallin (15) constitué d'un matériau de carbone destiné à être disposé sous un réacteur de dépôt fondu de silicium (1) pour recevoir le silicium polycristallin qui se déverse par gouttelettes de la surface intérieure du réacteur (1) vers l'extérieur du réacteur (1),
dans lequel au moins la surface intérieure dudit récipient (15) est recouverte d'une couche de traitement de surface pour empêcher l'eau d'être libérée par le matériau de carbone, ladite couche de traitement de surface étant une couche de SiC ;
dans lequel :
ledit récipient de silicium polycristallin (15) est fabriqué par l'empilement de nombreux blocs de matériaux de carbone ;
chacun des blocs est traité sur sa surface entière avec la couche de traitement de surface ; et
la couche de traitement de surface est formée par l'application et la cuisson d'une pâte, la pâte comprenant une poudre de silicium et une résine de liaison.
